# EUROPEAN PATENT APPLICATION

(11) **EP 1 632 956 A1**
(43) Date of publication of application: **08.03.2006**
(21) Application number: 05255435.9
(22) Date of filing: 06.09.2005
(51) Int. Cl.: H01B 3/46, C08L 83/04, C08J 9/26

(54) **Compositions comprising an organic polysilica and an arylgroup-capped polyol, and methods for preparing porous organic polysilica films**

(30) Priority: 07.09.2004 US 607814 P
(71) Applicant: Rohm and Haas Electronic Materials, L.L.C., Marlborough, Massachusetts 01752 (US)
(72) Inventor: Prokopowicz, Gregory P., Lancaster, Massachusetts 01523 (US); Gallagher, Michael K., Hopkinton, Massachusetts 01748 (US)
(74) Representative: Kent, Venetia Katherine

(57) **Abstract**

Compositions useful in the preparation of porous organic polysilica films, particularly for use in the manufacture of integrated circuits, are provided. Methods of forming such compositions and films are also provided.

## Description

### Background of the Invention

This invention relates generally to porous materials. In particular, this invention relates to the preparation and use of porous films containing organic polysilica materials.

As electronic devices become smaller, there is a need to increase the circuit density in electronic components, e.g., integrated circuits, circuit boards, multichip modules, chip test devices, and the like, without degrading electrical performance, e.g., crosstalk or capacitive coupling, and also to increase the speed of signal propagation in these components. One method of accomplishing these goals is to reduce the dielectric constant of the interlayer, or intennetal, insulating material used in the components.

A variety of organic and inorganic porous dielectric materials are known in the art in the manufacture of electronic devices, particularly integrated circuits. Suitable inorganic dielectric materials include silicon dioxide and organic polysilicas. Suitable organic dielectric materials include thermosets such as polyimides, polyarylene ethers, polyarylenes, polycyanurates, polybenzoxazoles, benzocyclobutenes, fluorinated materials such as poly(fluoroalkanes), and the like. Of the organic polysilica dielectrics, the alkyl silsesquioxanes such as methyl silsesquioxane are of increasing importance because of their low dielectric constant.

A method for reducing the dielectric constant of interlayer, or intermetal, insulating material is to incorporate within the insulating film very small, uniformly dispersed pores or voids. In general, such porous dielectric materials may be prepared by first incorporating a removable material (porogen) into a B-staged dielectric material, disposing the B-staged dielectric material containing the porogen onto a substrate, curing the B-staged dielectric material and then removing the porogen to form a porous dielectric material.

After the porous dielectric material is formed, it is subjected to conventional processing conditions of patterning, etching apertures, optionally applying a barrier layer and/or seed layer, filling the apertures with metal, planarizing the metal layer, and then applying a cap layer or etch stop. In a multilayer stack, such process is repeated until the desired levels of the device are obtained.

One problem with such porous materials in certain applications is that apertures etched into such porous dielectric materials suffer from sidewall roughness due to the pores in the dielectric material. Such sidewall roughness creates difficulties in the subsequent deposition of metal layers such as barrier or seed layers. The barrier or seed layers are typically chemically or physically vapor deposited. Roughness in the aperture sidewalls tends to create discontinuities in the barrier and/or seed layers, which can adversely affect subsequent the performance of electronic devices. One solution to this problem is to remove any porogen from the dielectric material later in the integration process, such as after metal deposition and subsequent planarization.

Such processes where the porogen is removed later in the integration process impose different requirements on the porogens than conventional processes. For example, the porogens must be stable to certain processing conditions and temperatures and yet remain easily removable when subjected to other processing conditions. U.S. Patent No. 6,271,273 (You et al.) discloses certain porogens useful in forming porous organic polysilica films. However, such porogens do not always possess the desired stability to all processing conditions such as certain etching conditions. There is a need for porogens useful in forming organic polysilica films that are stable to certain processing conditions and yet can be readily removed when desired.

### Summary of the Invention

Porogens containing a polyol moiety wherein substantially all of the hydroxyl groups of the polyol moiety have been capped with an aryl group-containing organic radical have been found to have good stability under various processing conditions and yet remain readily removable.

The present invention provides a composition including a B-staged organic polysilica material and a porogen, wherein the porogen includes an aryl group-containing organic radical-capped polyol moiety. Such polyol moiety is substantially free of hydroxyl groups.

Also provided by the present invention is a method of preparing porous organic polysilica dielectric materials including the steps of: a) disposing the above-described composition on a substrate; b) curing the B-staged organic polysilica dielectric material to form an organic polysilica film without substantially degrading the porogen; and c) subjecting the organic polysilica film to conditions which at least partially remove the porogen to form a porous organic polysilica film.

The present invention further provides an method of manufacturing an electronic device including the step of forming a porous organic polysilica film as described above.

In addition, the present invention provides an electronic device including a substrate and an organic polysilica, film, wherein the film includes a porogen including an aryl group-containing organic radical-capped polyol moiety.

### Brief Description of the Drawing

Figs. 1A-1B illustrate electronic devices according to the present invention, not to scale.
Figs. 2A-2E illustrate one process of manufacturing an electronic device according to the present invention.
Figs. 3A-3D illustrate one embodiment of air gap formation according to the invention, not to scale.
Figs. 4A-4D illustrate another embodiment of air gap formation according to the invention, not to scale.
Figs. 5A-5E illustrate another embodiment of air gap formation according to the invention, not to scale.

### Detailed Description of the Invention

As used throughout this specification, the following abbreviations shall have the following meanings, unless the context clearly indicates otherwise: ° C = degrees centigrade; UV = ultraviolet; nm = nanometer; g = gram; wt% = weight percent; L = liter; Mn = number average molecular weight; Mw = weight average molecular weight; and µm = micron = micrometer.

The term "(meth)acrylic" includes both acrylic and methacrylic and the term "(meth)acrylate" includes both acrylate and methacrylate. Likewise, the term "(meth)acrylamide" refers to both acrylamide and methacrylamide. The term "alkyl" includes straight chain, branched and cyclic alkyl groups. "Cross-linker" and "cross-linking agent" are used interchangeably throughout this specification- "Polymer" refers to polymers and oligomers, and also includes homopolymers and copolymers. The terms "oligomer" and "oligomeric" refer to dimers, trimers, tetramers and the like. "Monomer" refers to any ethylenically or acetylenically unsaturated compound capable of being polymerized or other compound capable of being polymerized by condensation. Such monomers may contain one or more double or triple bonds or groups capable of being polymerized by condensation. Such double or triple bonds are typically carbon-carbon double or triple bonds.

As used throughout the specification, "feature" refers to the geometries on a substrate. "Apertures" refer to recessed features, such as vias and trenches.

The term "porogen" refers to any removable material added to an organic polysilica dielectric material as a pore forming material, that is a material such as polymeric particles dispersed in a dielectric material that is subsequently removed to yield pores in the dielectric material. The term "pore" refers to voids formed in the dielectric material.

The term "B-staged" refers to uncured dielectric materials. By "uncured" is meant any material that can be polymerized or cured to form higher molecular weight materials, such as coatings or films. As used herein, "partially cured" refers to a film or coating of dielectric material that has been sufficiently cured so that only 1% or less of the thickness of the film is lost upon contact with a solvent suitable for dissolving the B-staged organic polysilica resin. Such partially cured films or coatings may undergo further curing during subsequent processing steps. "Layers" include "films". A "film" refers to an at-least partially cured or at-least partially polymerized layer. B-staged materials may be monomeric, oligomeric or mixtures thereof "B-staged material" is further intended to include mixtures of polymeric material with monomers, oligomers or a mixture of monomers and oligomers.

The articles "a" and "an" refer to the singular and the plural. Unless otherwise noted, all amounts are percent by weight and all ratios are by weight. All numerical ranges are inclusive and combinable in any order, except where it is clear that such numerical ranges are constrained to add up to 100%. In the figures, like reference numerals refer to like elements.

The present invention provides a composition including a B-staged organic polysilica material and a porogen, wherein the porogen includes an aryl group-containing organic radical-capped polyol moiety. By "B-staged organic polysilica" material is meant a compound including silicon, carbon and oxygen. In one embodiment, suitable B-staged organic polysilica materials are hydrolyzates or partial condensates including one or more silanes of formula (I), (II) or both (I) and (II):

RₐSiY₄₋ₐ (I)

R¹_{b}(R²O)_{3-b}Si(R³)_{c}Si(OR⁴)_{3-d}R⁵_{d} (II)

wherein R is hydrogen, (C₁-C₈)alkyl, (C₇-C₁₂)arylalkyl, substituted (C₇-C₁₂)arylalkyl, aryl, and substituted aryl; Y is any hydrolyzable group; a is an integer of 0 to 2; R¹, R², R⁴ and R⁵ are independently selected from hydrogen, (C₁-C₆)alkyl, (C₇-C₁₂)arylalkyl, substituted (C₇-C₁₂)arylalkyl, aryl, and substituted aryl; R³ is selected from (C₁₋C₁₀)alkylene, -(CH₂)ₕ-, -(CH₂)ₕ₁-Eₖ-(CH₂)ₕ₂-, -(CH₂)ₕ-Z, arylene, substituted arylene, and arylene ether; E is selected from oxygen, NR⁶ and Z; Z is selected from arylene and substituted arylene; R⁶ is selected from hydrogen, (C₁-C₆)alkyl, aryl and substituted aryl; band d are independently an integer of 0 to 2; c is an integer of 0 to 6; and h, h1, h2 and k are independently an integer from 1 to 6; provided that at least one of R, R¹ R³ and R⁵ is not hydrogen. "Substituted arylalkyl", "substituted aryl" and "substituted arylene" refer to an arylalkyl, aryl or arylene group having one or more of its hydrogens replaced by another substituent group, such as cyano, hydroxy, mercapto, halo, (C₁-C₆)alkyl, (C₁₋C₆)alkoxy, and the like. Typically, R is (C₁-C₄)alkyl, benzyl, hydroxybenzyl, phenethyl or phenyl, and more typically methyl, ethyl, iso-butyl, tert-butyl or phenyl. In one embodiment, a is 1. Suitable hydrolyzable groups for Y include, but are not limited to, halo, (C₁-C₆)alkoxy, acyloxy and the like. Preferred hydrolyzable groups are chloro and (C₁-C₂)alkoxy. In another embodiment, c is an integer of 1 to 6 and typically I to 4.

Suitable organosilanes of formula (I) include, but are not limited to, methyl trimethoxysilane, methyl triethoxysilane, phenyl trimethoxysilane, phenyl triethoxysilane, tolyl trimethoxysilane, tolyl triethoxysilane, propyl tripropoxysilane, iso-propyl triethoxysilane, iso-propyl tripropoxysilane, ethyl trimethoxysilane, ethyl triethoxysilane, iso-butyl triethoxysilane, iso-butyl trimethoxysilane, tert-butyl triethoxysilane, tert-butyl trimethoxysilane, cyclohexyl trimethoxysilane, cyclohexyl triethoxysilane, benzyl trimethoxysilane, benzyl triethoxysilane, phenethyl trimethoxysilane, hydroxybenzyl trimethoxysilane, hydroxyphenylethyl trimethoxysilane and hydroxyphenylethyl triethoxysilane.

Organosilanes of formula (II) typically include those wherein R¹ and R⁵ are independently (C₁-C₄)alkyl, benzyl, hydroxybenzyl, phenethyl or phenyl. More typically, R¹ and R⁵ are methyl, ethyl, tert-butyl, iso-butyl and phenyl. In a further embodiment, b and d are independently 1 or 2. Preferably R³ is (C₁-C₁₀)alkylene, -(CH₂)ₕ-, arylene, arylene ether and -(CH₂)ₕ₁,-E-(CH₂)ₕ₂. Suitable compounds of formula (II) include, but are not limited to, those wherein R³ is methylene, ethylene, propylene, butylene, hexylene, norbomylene, cycloheylene, phenylene, phenylene ether, naphthylene and -CH₂-C₆H₄-CH₂-.

Exemplary organosilanes of formula (II) include, without limitation, bis(hexamethoxysilyl)methane, bis(hexaethoxysilyl)methane, bis(hexaphenoxysilyl)methane, bis(dimethoxymethylsilyl)methane, bis(diethoxymethylsilyl)methane, bis(dimethoxyphenylsilyl)methane, bis(dietboxyphenylsilyl)methane, bis(methoxydimethylsilyl)methane, bis(ethoxydimethylsilyl)methane, bis(methoxydiphenylsilyl)methane, bis(ethoxydiphenylsilyl)methane, bis(hexamethoxysilyl)ethane, bis(hexaethoxysilyl)ethane, bis(hexaphenoxysilyl)ethane, bis(dimethoxymethylsilyl) ethane, bis(diethoxymethylsilyl)ethane, bis(dimethoxyphenylsilyl)ethane, bis(diethoxyphenyl-silyl)ethane, bis(methoxydimethylsilyl)ethane, bis(ethoxydimethylsilyl)ethane, bis(methoxy-diphenylsilyl)ethane, bis(ethoxydiphenylsilyl)ethane, 1,3-bis(hexamethoxysilyl))propane, 1,3-bis(hexaethoxysityl)propane, 1,3-bis(hexaphenoxysilyl)propane, 1,3-bis(dimethoxymethylsilyl)propane, 1,3-bis(diethoxymethylsilyl)propane, 1,3-bis(dimethoxyphenylsilyl)propane, 1,3-bis(diethoxyphenylsilyl)propane, 1,3-bis(methoxydimehylsilyl)propane, 1,3-bis(ethoxydimethylsilyl)propane, 1,3-bis(methoxydiphenylsilyl)propane, and 1,3-bis(ethoxydiphenylsilyl)propane. Preferred of these are hexamethoxydisilane, hexaethoxydisilane, hexaphenoxydisilane, 1,1,2,2-tetramethoxy-1,2-dimethyldisilane, 1,1,2,2-tetraethoxy-1,2-dimethyldisilane, 1,1,2,2-tetramethoxy-1,2-diphenyldisilane, 1,1,2,2-tetraethoxy-1,2-diphenyldisilane, 1,2-dimethoxy-1,1,2,2-tetramethyldisilane, 1,2-diethoxy-1,1,2,2-tetramethyldisilane, 1,2-dimethoxy-1,1,2,2-tetraphenyldisilane, 1,2-diethoxy-1,1,2,2-tetraphenyl-disilane, bis(hexamethoxysilyl)methane, bis(hexaethoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethyl-silyl)methane, bis(methoxydiphenylsilyl)methane, and bis(ethoxydiphenylsilyl)methane.

When the B-staged organic polysilica resins include only a hydrolyzate or partial condensate of organosilanes of formula (II), c may be 0, provided that at least one of R¹ and R⁵ are not hydrogen. In an alternate embodiment, the B-staged organic polysilica resins may comprise a cohydrolyzate or partial cocondensate of organosilanes of both formulae (I) and (11). In such cohydrolyzates or partial cocondensates, c in formula (II) can be 0, provided that at least one of R, R¹ and R⁵ is not hydrogen. Suitable silanes of formula (II) where c is 0 include, without limitation, hexamethoxydisilane, hexaethoxydisilane, hexaphenoxydisilane, 1,1,1,2,2-pentamethoxy-2-methyldisilane, 1,1,1,2,2-pentaethoxy-2-methyldisilane, 1,1,1,2,2-pentamethoxy-2-phenyldisilane, 1.1,1,2,2-pentaethoxy-2-phenyldisilane, 1,1,2,2-tetramethoxy-1,2-dimethyldisilane, 1,1,2,2-tetraethoxy-1,2-dimethyldisilane, 1,1,2,2-tetramethoxy-1,2-diphenyldisilane, 1,1,2,2-tetraethoxy-1,2-diphenyldisilane, 1,1,2-trimethoxy-1,2,2-trimethyldisilane, 1,1,2-triethoxy-1,2,2-trimethyldisilane, 1,1,2-trimethoxy-1,2,2-triphenyldisilane, 1,1,2-triethoxy-1,2,2-triphenyldisilane, 1,2-dimethoxy-1,1,2,2-tetramethyldisilane, 1.2-diethoxy-1,1,2,2-tetramethyldisilane, 1,2-dimethoxy-1,1,2,2-tetraphenyldisilane, and 1,2-diethoxy-1,1,2,2-tetra-phenyldisilane.

In one embodiment, particularly suitable B-staged organic polysilica resins are hydrolyzates or partial condensates of one or more compounds of formula (I). Such B-staged organic polysilica resins have the formula (III):

((R⁷R⁸SiO)ₑ(R⁹SiO_{1.5})_{f}(R¹⁰SiO_{1.5})_{g}(SiO₂)ᵣ)ₙ (III)

wherein R⁷, R⁸, R⁹ and R¹⁰ are independently selected from hydrogen, (C₁-C₆)alkyl, (C₇₋C₁₂)arylalkyl, substituted (C₇-C₁₂)arylalkyl, aryl, and substituted aryl; e, g and r are independently a number from 0 to 1; f is a number from 0.2 to 1; n is integer from 3 to 10,000; provided that e + f + g + r = 1; and provided that at least one of R⁷, R⁸ and R⁹ is not hydrogen. In the above formula (III), e, f, g and r represent the mole ratios of each component. Such mole ratios can be varied between 0 and 1. It is preferred that e is from 0 to 0.8. It is also preferred that g is from 0 to 0.8. It is further preferred that r is from 0 to 0.8. In the above formula, n refers to the number of repeat units in the B-staged material. Preferably, n is an integer from 3 to 1000.

Suitable organic polysilica materials include, but are not limited to, silsesquioxanes, partially condensed halosilanes or alkoxysilanes such as partially condensed by controlled hydrolysis tetraethoxysilane having number average molecular weight of 500 to 20,000, organically modified silicates having the composition RSiO₃, O₃SiRSiO₃, R₂SiO₂ and O₂SiR₃SiO₂ wherein R is an organic substituent, and partially condensed orthosilicates having Si(OR)₄ as the monomer unit. Silsesquioxanes are polymeric silicate materials of the type RSiO_{1.5} where R is an organic substituent. Suitable silsesquioxanes are alkyl silsesquioxanes such as methyl silsesquioxane, ethyl silsesquioxane, propyl silsesquioxane, butyl silsesquioxane and the like; aryl silsesquioxanes such as phenyl silsesquioxane and tolyl silsesquioxane; alkyl/aryl silsesquioxane mixtures such as a mixture of methyl silsesquioxane and phenyl silsesquioxane; and mixtures of alkyl silsesquioxanes such as methyl silsesquioxane and ethyl silsesquioxane. B-staged silsesquioxane materials include homopolymers of silsesquioxanes, copolymers of silsesquioxanes or mixtures thereof. Such materials are generally commercially available or may be prepared by known methods.

In an alternate embodiment, the organic polysilica materials may contain a wide variety of other monomers in addition to the silicon-containing monomers described above. For example, the organic polysilica resins may further comprise cross-linking agents, and carbosilane moieties. Such cross-linking agents may be any of the cross-linking agents described elsewhere in this specification, or any other known cross-linkers for silicon-containing materials. It will be appreciated by those skilled in the art that a combination of cross-linkers may be used. Carbosilane moieties refer to moieties having a (Si-C)ₓ structure, such as (Si-A)ₓ structures wherein A is a substituted or unsubstituted alkylene or arylene, such as SiR₃CH₂-, -SiR₂CH₂-, =SiRCH₂-, and =SiCH₂-, where R is usually hydrogen but may be any organic or inorganic radical. Suitable inorganic radicals include organosilicon, siloxyl, or silanyl moieties. These carbosilane moieties are typically connected "head-to-tail", i.e. having Si-C-Si bonds, in such a manner that a complex, branched structure results. Particularly useful carbosilane moieties are those having the repeat units (SiHₓCH₂) and (SiH_{y-1}(CH=CH₂)CH₂), where x = 0 to 3 and y = 1 to 3. These repeat units may be present in the organic polysilica resins in any number from 1 to 100,000, and preferably from 1 to 10,000. Suitable carbosilane precursors are those disclosed in U.S. Patent Nos. 5,153,295 (Whitmarsh et al.) and 6,395,649 (Wu).

In one embodiment, the B-staged organic polysilica material includes a silsesquioxane, and more preferably methyl silsesquioxane, ethyl silsesquioxane, propyl silsesquioxane, iso-butyl silsesquioxane, tert-butyl silsesquioxane, phenyl silsesquioxane, tolyl silsesquioxane, benzyl silsesquioxane or mixtures thereof. Methyl silsesquioxane, phenyl silsesquioxane and mixtures thereof are particularly suitable. Other useful silsesquioxane mixtures include mixtures of hydrido silsesquioxanes with alkyl, aryl or alkyl/aryl silsesquioxanes. Typically, the silsesquioxanes useful in the present invention are used as oligomeric materials, generally having from 3 to 10,000 repeating units.

Other suitable organic polysilica B-staged resins are co-hydrolyzates or partial condensates of one or more organosilanes of formulae (I) and/or (II) and one or more tetrafunctional silanes having the formula SiY₄, where Y is any hydrolyzable group as defined above. Suitable hydrolyzable groups include, but are not limited to, halo, (C₁₋C₆)alkoxy, acyloxy and the like. Preferred hydrolyzable groups are chloro and (C₁₋C₂)alkoxy. Suitable tetrafunctional silanes of the formula SiY₄ include, but are not limited to, tetramethoxysilane, tetraethoxysilane, tetrachlorosilane, and the like. Particularly suitable silane mixtures for preparing the cohydrolyzates or partial cocondensates include: methyl triethoxysilane and tetraethoxysilane; methyl trimethoxysilane and tetramethoxysilane; phenyl triethoxysilane and tetraethoxysilane; methyl triethoxysilane and phenyl triethoxysilane and tetraethoxysilane; ethyl triethoxysilane and tetramethoxysilane; and ethyl triethoxysilane and tetraethoxysilane. The ratio of such organosilanes to tetrafunctional silanes is typically from 99:1 to 1:99, preferably from 95:5 to 5:95, more preferably from 90:10 to 10:90, and still more preferably from 80:20 to 20:80.

In a particular embodiment, the B-staged organic polysilica material is a co-hydrolyzate or partial co-condensate of one or more organosilanes of formula (I) and a tetrafunctional silane of formula SiY₄. In another embodiment, the B-staged organic palysilica resin is a co-hydrolyzate or partial co-condensate of one or more organosilanes of formula (II) and a tetrafunctional silane of formula SiY₄. In still another embodiment, the B-staged organic polysilica material is a co-hydrolyzate or partial co-condensate of one or more organosilanes of formula (I), one or more silanes of formula (II) and a tetrafunctional silane of formula SiY₄. The B-staged organic polysilica materials of the present invention include a non-hydrolyzed or non-condensed silane of one or more silanes of formulae (I) or (11) with the hydrolyzate or partial condensate of one or more silanes of formulae (I) or (II). In a further embodiment, the B-staged organic polysilica material includes a silane of formula (II) and a hydrolyzate of partial condensate of one or more organosilanes of formula (1), and preferably a co-hydrolyzate or partial co-condensate of one or more organosilanes of formula (I) with a tetrafunctional silane of the formula SiY₄ where Y is as defined above. Perferably, such B-staged organic polysilica material includs a mixture of one or more silanes of formula (II) and a co-hydrolyzate or partial co-condensate having the formula (RSiO_{1.5}) (SiO₂) where R is as defined above.

When organosilanes of formula (I) are co-hydrolyxed or co-condensed with a tetrafunctional silane, it is preferred that the organosilane of formula (I) has the formula RSiY₃, and preferably is selected from methyl trimethoxysilane, methyl triethoxysilane, ethyl trimethoxysilane, ethyl triethoxysilane, phenyl trimethoxysilane, phenyl triethoxysilane and mixtures thereof It is also preferred that the tetrafunctional silane is selected from tetramethoxysilane and tetraethoxysilane.

It will be appreciated that a mixture of dielectric materials may be used, such as two or more organic polysilica dielectric materials or a mixture of one or more organic polysilica dielectric materials and one or more other dielectric materials. Other suitable dielectric materials include, without limitation, inorganic materials such as carbides, oxides, nitrides and oxyfluorides of silicon, boron, or aluminum; and organic materials such as benzocyclobutenes, poly(aryl esters), poly(ether ketones), polycarbonates, poly(arylene ethers), polyaromatic hydrocarbons such as polynaphthalene, polyquinoxalines, poly(perfluorinated hydrocarbons) such as poly(tetrafluoroethylene), polyimides, polybenzoxazoles, polycycloolefins such as polynorbornenes, and polydicyclopentadienes. Such B-staged dielectric materials are generally commercially available or may be prepared by methods known in the literature. Thus, mixtures of alkyl/aryl silsesquioxanes, hydrido/alkyl silsesquioxanes, and organic polysilica-organic material hybrids may be used.

The porogens useful in the present invention are any which may be removed providing pores in the dielectric material chosen and reduce the dielectric constant of such material. A wide variety of porogens may be used in the present compositions. Such porogens include a polyol moiety wherein substantially all of the hydroxyl groups of the polyol moiety are capped with an aryl group-containing organic radical, i.e. the polyol moiety contains ≤ 2% of its hydroxyl groups as uncapped or free hydroxyls. In one embodiment, the polyol moiety contains ≤ 1% of its hydroxyls in uncapped form. A "polyol moiety" as used herein refers to a moiety having 2 or more hydroxyl groups. In particular, the capped polyol moiety of the present invention includes one or more alkylene oxide units. When the porogen of the present invention is a polymer, each monomer composing the polymer is considered to be a "moiety". It will be appreciated by those skilled in the art that the porogen may contain one or more other moieties, i.e. non-polyol moieties, which may contain free hydroxyl groups. By way of example, such other moieties include hydroxy-substituted alkyl (meth)acrylate monomers such as hydroxylethyl methacrylate.

The capped polyol moieties typically also contain one or more alkylene oxide units, i.e. a unit having the formula -(C₂-C₄O)-. Such alkylene oxide units include, without limitation, ethyleneoxy, propyleneoxy and butyleneoxy units. Combinations of such units, such as ethyleneoxy/propyleneoxy ("EO/PO"), may advantageously be employed. When mixtures of alkylene oxides are used, they may be random or block combinations. It is typically such alkylene oxide unit in the polyol moiety that is end capped with an aryl group-containing organic radical In one embodiment, the aryl group-containing organic radical-capped polyol moiety contains one or more units of the formula (-(OC₂-C₄)_{z}OR¹¹)_{z'} wherein each R¹¹ is independently chosen from aryl, (C₁₋C₆)alkylaryl, aracyl, and aroyl, z = 1-50 and z' = 1-10. Typically, z = 1-20, more typically 1-15, and still more typically 1-10 and refers to the repeat units of the alkylene oxide. The number of organic radical-capped polyol moieties is represented by z', which is typically 1-5 and more typically 1-3. Suitable aryl groups include, without limitation, those containing from 6 to 15 carbon atoms and which may optionally be substituted. Exemplary aryl groups include phenyl, tolyl, xylyl, acetoxyphenyl, methoxyphenyl, dimethoxyphenyl, and methoxytolyl. The (C₁-C₆)alkylaryl groups may optionally be substituted and include, without limitation, benzyl, phenylethyl, and phenylpropyl. Aracyl groups, which may be optionally substituted, typically have 8 to 18 carbon atoms and may have the general formula Ar(CH₂)ₙC(O)-, where n = 1-8 and Ar is an aryl group as defined above. Other aracyl groups include Ar-norbomenylene-C(O)-, Ar-cyclohenylene-C(O)-, and Ar-cyclopentylene-C(O)-. Aroyl groups, which may also be optionally substituted, typically have 7 to 16 carbon atoms and have the general formula ArC(O)-, where Ar is an aryl group as described above. By "substituted" it is meant that one or more hydrogens on the aryl or alkyl group be replaced with one or more substitutes, such as, but not limited to, (C₁-C₆)alkyl, (C₁-C₆)alkoxy, halogen, phenoxy, and (C₂-C₆)carbalkoxy. R¹¹ is typically chosen from phenyl, tolyl, benzyl, phenylethyl, phenacyl, and benzoyl and more typically phenyl.

In one embodiment, the capped polyol moieties of the present invention have the general formula R¹²((OC₂-C₄)_{z}OR¹¹)_{z},wherein R¹¹, z and z' are as defined above and R¹² is any organic radical, including a polymer backbone. The organic radical R¹² may be any suitable polyol compound. Suitable groups for R¹² include, but are not limited to, glycerol, pentacrithritol, sucrose, dipentaerithritol, trimethylolpropane, vinyl benzene carboxylic acid, trimesic acid, hemimellitic acid, trimellitic acid, gallic acid, and the like.

The capped polyol moieties of the invention are generally commercially available or may be prepared by methods known in the literature. For example, the present capped polyol moieties may be prepared by transesterification reactions or by ether synthesis, both of which are well known to those skilled in the art. Such capped polyol moieties may be used as is or may be further purified using any suitable means, such as high performance liquid chromatography. It may be advantageous, but not required, that the alkylene oxide unit nearest the aryl group-containing capping unit is an ethylene oxide unit.

In addition to the moieties described above, the porogen may include one or more additional moieties. The porogens may optionally be polymers such as polymeric particles, or may be monomers or polymers that are co-polymerized with a dielectric monomer to form a block copolymer having a labile (removable) component or may be a suitably high boiling compound. In an alternative embodiment, the porogen may be pre-polymerized with the dielectric monomer to form the B-staged dielectric material which may be monomeric, oligomeric or polymeric. Such pre-polymerized B-staged material is then cured to form a dielectric layer.

When the porogen is a polymer, it may further contain as polymerized units one or more monomers including, but not limited to, (meth)acrylic acid, (meth)acrylamides, alkyl (meth)acrylates, alkenyl (meth)acrylates, aromatic (meth)acrylates, vinyl aromatic monomers, nitrogen-containing compounds and their thio-analogs, and substituted ethylene monomers.

Typically, the alkyl (meth)acrylates useful in the present invention are (C₁-C₂₄) alkyl (meth)acrylates. Suitable alkyl (meth)acrylates include, but are not limited to: methyl methacrylate, methyl acrylate, ethyl acrylate, propyl methacrylate, butyl methacrylate, butyl acrylate, isobutyl methacrylate, hexyl methacrylate, cyclohexyl methacrylate, cyclohexyl acrylate, 2-ethylhexyl acrylate, 2-ethylhexyl methacrylate, octyl methacrylate, decyl methacrylate, isodecyl methacrylate (based on branched (C₁₀)alkyl isomer mixture), undecyl methacrylate, dodecyl methacrylate (also known as lauryl methacrylate), tridecyl methacrylate, tetradecyl methacrylate (also known as myristyl methacrylate), pentadecyl methacrylate, and mixtures thereof

The alkyl (meth)acrylate monomers useful in the present invention may be a single monomer or a mixture having different numbers of carbon atoms in the alkyl portion. Also, the (meth)acrylamide and alkyl (meth)acrylate monomers useful in the present invention may optionally be substituted. Suitable optionally substituted (meth)acrylamide and alkyl (meth)acrylate monomers include, but are not limited to: hydroxy (C₂-C₆)alkyl (meth)acrylates, dialkylamino(C₂-C₆)-alkyl (meth)acrylates, dialkylamino(C₂-C₆)alkyl (meth)acrylmides.

Particularly useful substituted alkyl (meth)acrylate monomers are those with one or more hydroxyl groups in the alkyl radical, especially those where the hydroxyl group is found at the β-position (2-position) in the alkyl radical. Hydroxyalkyl (meth)acrylate monomers in which the substituted alkyl group is a (C₂-C₆)alkyl, branched or unbranched, are preferred. Suitable hydroxyalkyl (meth)acrylate monomers include, but are not limited to: 2-hydroxyethyl methacrylate ("HEMA"), 2-hydroxyethyl acrylate ("HEA"), 2-hydroxypropyl methacrylate, 1-methyl-2-hydroxyethyl methacrylate, 2-hydroxy-propyl acrylate, 1-methyl-2-hydroxyethyl acrylate, 2-hydroxybutyl methacrylate, 2-hydroxybutyl acrylate and mixtures thereof.

Other substituted (meth)acrylate and (meth)acrylamide monomers useful in the present invention are those with a dialkylamino group or dialkylaminoalkyl group in the alkyl radical. Examples of such substituted (meth)acrylates and (meth)acrylamides include, but are not limited to: dimethylaminoethyl methacrylate, dimethylaminoethyl acrylate, N,N-dimethylaminoethyl methacrylamide, N,N-dimethyl-aminopropyl methacrylamide, N,N-dimethylaminobutyl methacrylamide, N,N-di-ethylaminoethyl methacrylamide, N,N-diethylaminopropyl methacrylamide, N,N-diethylaminobutyl methacrylamide, N-(1,1-dimethyl-3-oxobutyl) acrylamide, N-(1,3-diphenyl-1-ethyl-3-oxobutyl) acrylamide, N-(1-methyl-1-phenyl-3-oxobutyl) methacrylamide, and 2-hydroxyethyl acrylamide, N-methacrylamide of aminoethyl ethylene urea, N-methacryloxy ethyl morpholine, N-maleimide of dimethylaminopropylamine and mixtures thereof.

Other substituted (meth)acrylate monomers useful in the present invention are silicon-containing monomers such as γ-propyl tri(C₁-C₆)alkoxysilyl (meth)acrylate, γ-propyl tri(C₁-C₆)alkylsilyl (meth)acrylate, γ-propyl di(C₁-C₆)alkoxy(C₁-C₆)alkylsilyl (meth)acrylate, γ-propyl di(C₁-C₆)alkyl(C₁-C₆)alkoxysilyl (meth)acrylate, vinyl tri(C₁₋C₆)alkoxysilyl (meth)acrylate, vinyl di(C₁-C₆)alkoxy(C₁-C₆)alkylsilyl (meth)acrylate, vinyl (C₁-C₆)alkoxydi(C₁-C₆)alkylsilyl (meth)acrylate, vinyl tri(C₁-C₆)alkylsilyl (meth)acrylate, and mixtures thereof.

In one embodiment, the porogen is a polymer and includes as polymerized units one or more acrylate or methacrylate monomers of the general formula R¹²((OC₂₋C₄)_{z}OR¹¹)₂, wherein R¹¹, z and z' are as defined above and R¹² is acryl or methacryl. Such porogen polymer may also include as polymerized units one or more other ethylenically or acetylenically unsaturated monomers.

The vinylaromatic monomers useful in the present invention include, but are not limited to: styrene ("STY"), α-methylstyrene, vinyltoluene, *p*-methylstyrene, ethylvinylbenzene, vinylnaphthalene, vinylxylenes, and mixtures thereof. The vinylaromatic monomers also include their corresponding substituted counterparts, such as halogenated derivatives, i.e., containing one or more halogen groups, such as fluorine, chlorine or bromine; and nitro, cyano, (C₁-C₁₀)alkoxy, halo(C₁-C₁₀)alkyl, carb(C₁₋C₁₀)alkoxy, carboxy, amino, (C₁-C₁₀)alkylamino derivatives and the like.

The nitrogen-containing compounds and their thio-analogs useful as unsaturated monomers in the present invention include, but are not limited to: vinylpyridines such as 2-vinylpyridine or 4-vinylpyridine; lower alkyl (C₁-C₈) substituted N-vinyl pyridines such as 2-methyl-5-vinyl-pyridine, 2-ethyl-5-vinylpyridine, 3-methyl-5-vinylpyridine, 2,3-dimethyl-5-vinyl-pyridine, and 2-methyl-3-ethyl-5-vinylpyridine; methyl-substituted quinolines and isoquinolines; N-vinylcaprolactam; N-vinylbutyrolactam; N-vinylpyrrolidone; vinyl imidazole; N-vinyl carbazole; N-vinyl-succinimide; (meth)acrylonitrile; o-, m-, or *p*-aminostyrene, maleimide; N-vinyl-oxazolidone; N,N-dimethyl aminoethyl-vinyl-ether; ethyl-2-cyano acrylate; vinyl acetonitrile; N-vinylphthalimide; N-vinyl-pyrrolidones such as N-vinyl-thio-pyrrolidone, 3 methyl-1-vinyl-pyrrolidone, 4-methyl-1-vinyl-pyrrolidone, 5-methyl-1-vinyl-pyrrolidone, 3-ethyl-1-vinyl-pyrrolidone, 3-butyl-1-vinyl-pyrrolidone, 3,3-dimethyl-1-vinyl-pyrrolidone, 4,5-dimethyl-1-vinyl-pyrrolidone. 5,5-dimethyl-1-vinyl-pyrrolidone, 3,3,5-trimethyl-1-vinylpyrrolidone, 4-ethyl-1-vinyl-pyrrolidone, 5-methyl-5-ethyl-1-vinyl-pyrrolidone and 3,4,5-trimethyl-1-vinyl-pyrrolidone; vinyl pyrroles; vinyl anilines; and vinyl piperidines.

The substituted ethylene monomers useful as unsaturated monomers is in the present invention include, but are not limited to: vinyl acetate, vinyl formamide, vinyl chloride, vinyl fluoride, vinyl bromide, vinylidene chloride, vinylidene fluoride and vinylidene bromide.

The polymers useful as porogens in the present invention are generally commercially available or may be prepared by a variety of polymerization techniques known in the art, such as solution polymerization or emulsion polymerization, and preferably by solution polymerization. The polymers useful as porogens may be linear, branched or grafted and may be copolymers or homopolymers. The use of certain chain transfer agents in free-radical polymerizations of these polymers and/or the use of certain initiators may enhance the stability of the porogen in the dielectric material during certain processing conditions.

Suitable cross-linkers useful in the present porogens include di-, tri-, tetra-, or higher ethylenically unsaturated monomers. Exemplary cross-linkers include, but are not limited to: trivinylbenzene, divinyltoluene, divinylpyridine, divinylnaphthalene and divinylxylene; and such as ethyleneglycol diacrylate, trimethylolpropane triacrylate, diethyleneglycol divinyl ether, trivinylcyclohexane, allyl methacrylate, ethyleneglycol dimethacrylate, diethyleneglycol dimethacrylate, propyleneglycol dimethacrylate, propyleneglycol diacrylate, trimethylolpropane trimethacrylate ("TMPTMA"), divinyl benzene ("DVB''), glycidyl methacrylate, 2,2-dimethylpropane 1,3 diacrylate, 1,3-butylene glycol diacrylate, 1,3-butylene glycol dimethacrylate, 1,4-butanediol diacrylate, diethylene glycol diacrylate, diethylene glycol dimethacrylate, 1,6-hexanediol diacrylate, 1,6-hexanediol dimethacrylate, tripropylene glycol diacrylate, triethylene glycol dimethacrylate, tetraethylene glycol diacrylate, polyethylene glycol 200 diacrylate, tetraethylene glycol dimethacrylate, polyethylene glycol dimethacrylate, ethoxylated bisphenol A diacrylate, ethoxylated bisphenol A dimethacrylate, polyethylene glycol 600 dimethacrylate, poly(butanediol) diacrylate, pentaerythritol triacrylate, trimethylolpropane triethoxy triacrylate, glyceryl propoxy triacrylate, pentaerythritol tetraacrylate, pentaerythritol tetramethacrylate, dipentaerythritol monohydroxypentaacrylate, and mixtures thereof. Silyl containing monomers that are capable of undergoing cross-linking may also be used as cross-linkers, such as, but not limited to, divinylsilane, trivinylsilane, dimethyldivinylsilane, divinylmethylsilane, methyltrivinylsilane, diphenyldivinylsilane, divinylphenylsilane, trivinylphenylsilane, divinylmethylphenylsilane, tetravinylsilane, dimethylvinyldisiloxane, poly(methylvinyisiloxane), poly(vinylhydrosiloxane), poly(phenylvinylsiloxane), tetraallylsilane, 1,3-dimethyl tetravinyldisiloxane, 1,3-divinyl tetramethyldisiloxane and mixtures thereof.

When the porogens are polymers, they typically have a number average molecular weight in the range of 5000 to 1,000,000, preferably 10,000 to 500,000, and more preferably 20,000 to 100,000. The polydispersity of these materials is in the range of 1 to 20, preferably 1.001 to 15, and more preferably 1.001 to 10. Narrow polydispersities, i.e. polydispersities from 1.001 to 2, may also provide enhanced stability of the porogen during certain processing conditions. Those skilled in the art will appreciate that the molecular weight of the polymer as well as other polymerization conditions may also add top the polymer stability during certain processing conditions of dielectric films.

Polymer particles useful as porogens are typically cross-linked. Typically, the amount of cross-linking agent is at least 1% by weight, based on the weight of the porogen. Up to and including 100% cross-linking agent, based on the weight of the porogen, may be effectively used in the particles of the present invention. In general, the amount of cross-linker is from 1% to 80%, and more typically from 1% to 60%.

Other suitable porogens include branched compounds composed of a central polyol moiety reacted with one or more alkylene oxides and one or more organic radical capping groups. For example, compounds that are reaction products of glycerol with ethylene oxide or propylene oxide or both ethylene oxide and propylene oxide and then capped with methyl or phenyl groups are particularly useful in the present invention.

In one embodiment, the porogen is substantially non-aggregated or non-agglomerated in the B-staged dielectric material. Such non-aggregation or non-agglomeration reduces or avoids the problem of large pore ("killer pore") or channel formation in the dielectric film. In a further embodiment, the porogen is a polymeric particle or is co-polymerized with the dielectric monomer. When the porogen is a polymeric particle, it is preferred that the porogen particle is substantially compatible with the B-staged dielectric material. By "substantially compatible" is meant that a composition of B-staged dielectric material and porogen is slightly cloudy or slightly opaque. Preferably, "substantially compatible" means at least one of a solution of B-staged dielectric material and porogen, a film or layer including a composition of B-staged dielectric material and porogen, a composition including a dielectric material having porogen dispersed therein, and the resulting porous dielectric material after removal of the porogen is slightly cloudy or slightly opaque. To be compatible, the porogen must be soluble or miscible in the B-staged dielectric material, in the solvent used to dissolve the B-staged dielectric material or both. Suitable compatibilized porogens for organic polysilica films are those disclosed in U.S. Patent No. 6,271,273 (You et al.).

The porogen particles of the present invention may be directly added to the B-staged organic polysilica dielectric matrix material as is or may be first purified to remove impurities that might effect the electrical or physical properties of electronic devices. Purification of the porogen particles may be accomplished either by precipitation of the porogen particles or adsorption of the impurities.

To be useful in forming porous dielectric materials, the porogens of the present invention must be at least partially removable under conditions which do not adversely affect the dielectric material, preferably substantially removable, and more preferably completely removable. By "removable" is meant that the porogen volatilizes, depolymerizes or otherwise breaks down into volatile components or fragments which are then removed from, or migrate out of, the dielectric material yielding pores. Any procedures or conditions which at least partially remove the porogen without adversely affecting the dielectric matrix material may be used. Typical methods of removal include, but are not limited to: exposure to heat, pressure, vacuum or radiation such as, but not limited to, actinic, IR, microwave, UV, x-ray, gamma ray, alpha particles, neutron bearn or electron beam. It will be appreciated that more than one method of removing the porogen or polymer may be used, such as a combination of heat and actinic radiation. It is preferred that the matrix material is exposed to heat or UV light or a combination of these to remove the porogen. It will also be appreciated by those skilled in the art that other methods of porogen removal, such as by atom abstraction, may be employed.

The porogens of the present invention can be thermally removed in air, under vacuum, or other atmosphere such as nitrogen, argon, mixtures of nitrogen and hydrogen, such as forming gas, or other inert or reducing atmosphere. The porogens of the present invention may be removed at any temperature that is higher than the thermal curing temperature and lower than the thermal decomposition temperature of the dielectric material. Typically, the porogens of the present invention may be removed at temperatures in the range of 150° to 450° C and preferably in the range of 250° to 425° C. Typically, the porogens are removed upon from the dielectric film in a time of 1 to 120 minutes. After removal from the dielectric material, typically 0 to 20% by weight of the porogen remains in the porous dielectric material, and more typically 0 to 10%..

In one embodiment, when a porogen of the present invention is removed by exposure to radiation, the porogen polymer is typically exposed under an inert atmosphere, such as nitrogen, to a radiation source, such as, but not limited to, visible or ultraviolet light. While not intending to be bound by theory, it is believed that porogen fragments form, such as by radical decomposition, and are removed from the dielectric material under a flow of inert gas. The energy flux of the radiation must be sufficiently high such that porogen particles are at least partially removed.

In preparing the porous dielectric materials of the present invention, the porogens described above are first dispersed within, or dissolved in, a B-staged organic polysilica dielectric material. Any amount of porogen may be combined with the B-staged organic polysilica dielectric materials according to the present invention. The amount of porogen used will depend on the particular porogen employed, the particular B-staged organic polysilica dielectric material employed, and the extent of dielectric constant reduction desired in the resulting porous dielectric material. Typically, the amount of porogen used is in the range of from 1 to 90 wt%, based on the weight of the B-staged organic polysilica dielectric material, preferably from 10 to 80 wt%, and more preferably from 15 to 60 wt%. A particularly useful amount ofporogen is in the range of form about 1 to about 60 wt%.

The porogens may be combined with the B-staged organic polysilica dielectric material by any methods known in the art. Typically, the B-staged matrix material is first dissolved in a suitable high boiling solvent, such as, but not limited to, methyl isobutyl ketone, diisobutyl ketone, 2-heptanone, γ-butyrolactone, ε-caprolactone, ethyl lactate propyleneglycol monomethyl ether acetate, propyleneglycol monomethyl ether, diphenyl ether, anisole, n-amyl acetate, n-butyl acetate, cyclohexanone, N-methyl-2-pyrrolidone, N,N'-dimethylpropyleneurea, mesitylene, xylenes, or mixtures thereof, to form a solution. The porogens are then dispersed or dissolved within the solution. The resulting solution or dispersion is then deposited on a substrate by methods known in the art, such as spin coating, spray coating or doctor blading, to form a film or layer.

After being deposited on a substrate, the B-staged organic polysilica dielectric material is then substantially cured to form a rigid, cross-linked organic polysilica dielectric material film without substantially removing the porogen particle. The curing of the organic polysilica dielectric material may be by any means known in the art including, but not limited to, heating to induce condensation or e-beam irradiation to facilitate free radical coupling of the oligomer or monomer units. Typically, the B-staged material is cured by heating at an elevated temperature, e.g. either directly, e.g. heated at a constant temperature such as on a hot plate, or in a step-wise manner. Such curing conditions are known to those skilled in the art.

Following curing of the organic polysilica film, the porogen is removed. In conventional processes, the porogen is removed prior to any subsequent manufacturing steps. In such a conventional process, the organic polysilica film containing porogens is typically first annealed at a temperature of from about 200° to about 350° C, and then heated to a higher temperature, such as from about 400° to about 450° C to at least partially remove the porogens.

Upon removal of the porogens, a porous organic polysilica dielectric material is obtained. In general, the size of the pores is substantially the same as the particle size of the porogen used. The resulting dielectric material having pores thus has a lower dielectric constant than such material without such pores. In general, pore sizes of up to about 1,000 nm, such as that having a mean particle size in the range of 0.5 to 1000 nm, are obtained. It is preferred that the mean pore size is from 0.5 to 200 nm, more preferably from 0.5 to 50 nm, and most preferably from 1 nm to 20 nm.

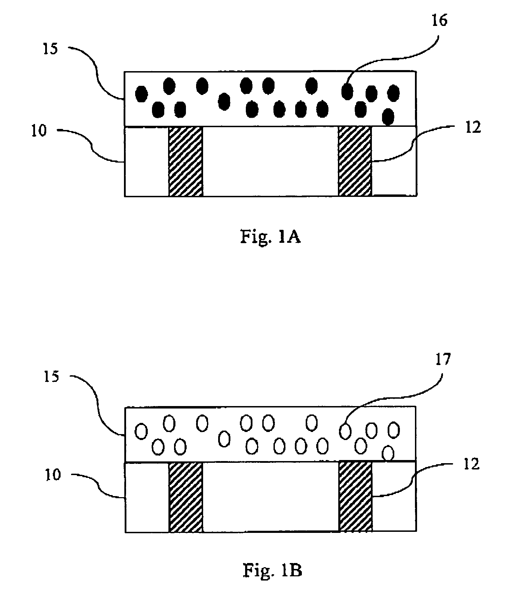

Fig. 1A illustrates an electronic device containing substrate **10,** such as a wafer used in the manufacture of integrated circuits, having metal lines **12** and cured organic polysilica dielectric film **15** including parogens **16** including an organic radical-capped polyol moiety. The porogens **16** are not shown to scale and are shown as oval. It will be appreciated that the porogens may be any suitable shape, such as spherical. Fig. 1B illustrates the electronic device of Fig. 1A following removal of the porogens, such as by the use of heat, to form pores **17** in organic polysilica dielectric film **15.** Such device may then be processed using any conventional procedures for porous films.

In the manufacture of electronic devices, the organic polysilica dielectric film is typically patterned and etched to produce apertures. Typically, such patterning involves (i) coating the dielectric film with a positive or negative photoresist, such as those marketed by Rohm and Haas Electronic Materials (Marlborough, MA); (ii) imagewise exposing, through a mask, the photoresist to radiation, such as light of appropriate wavelength or e-beam; (iii) developing the image in the resist, e.g., with a suitable developer; and (iv) transferring the image through the dielectric film to the substrate with a suitable transfer technique such as reactive ion etching or wet etching. Such etching creates apertures in the dielectric film. Optionally, an antireflective layer is disposed between the photoresist layer and the dielectric film. Such lithographic patterning techniques are well known to those skilled in the art.

After the apertures are formed, a first metal layer, such as a barrier layer or seed layer, may optionally be deposited on the surface of the organic polysilica film using suitable techniques, such as by atomic layer deposition ("ALD"), chemical vapor deposition ("CVD") or physical vapor deposition ("PVD"). Barrier layers are typically used with copper to prevent migration of copper into the dielectric material and are typically thin as compared to the metallization layer. Such barrier layers may be conductive, semi-conductive or non-conductive. Suitable barrier layers include, but are not limited to, one or more of tantalum, tantalum nitride, tantalum nitride silicide, titanium, titanium nitride, tungsten, tungsten nitride and tungsten nitride silicide. More than one barrier layer may be used, such as titanium followed by titanium nitride and optionally followed by titanium nitride silicide. The barrier layers may be discrete layers or they may be graduated, such as, for example, going from titanium on the bottom through a titanium sub-stoichiometric nitride to a titanium stoichiometric nitride upper layer.

Seed layers, when used, may be applied to the dielectric material as the first metal layer or applied to a previously deposited barrier layer. Suitable seed layers include copper or copper alloys. When a seed layer is used without a barrier layer, it is preferred that the seed layer is not copper. Such seed layers may also be deposited by CVD or PVD and are thin as compared to metallization layers. Alternatively, seed layers may be applied electrolessly. Thus, seed layers include catalysts for electroless plating.

Following such barrier and/or seed layer deposition, the aperture may be metallized or filled, such as with copper or copper alloy. Such metallization may be by any means, but is preferably at least partially electrolytic, and more preferably electrolytic. Methods of metallizing such apertures are well known to those skilled in the art. For example, ULTRAFILL™ 2001 EP copper deposition chemistries, available from Rohm and Haas Electronic Materials, may be used for electrolytic copper metallization of apertures. In the alternative, the apertures may be metallized or filled electrolessly without the need for barrier or seed layers. If apertures are electrolessly metallized with copper, a barrier layer is preferred.

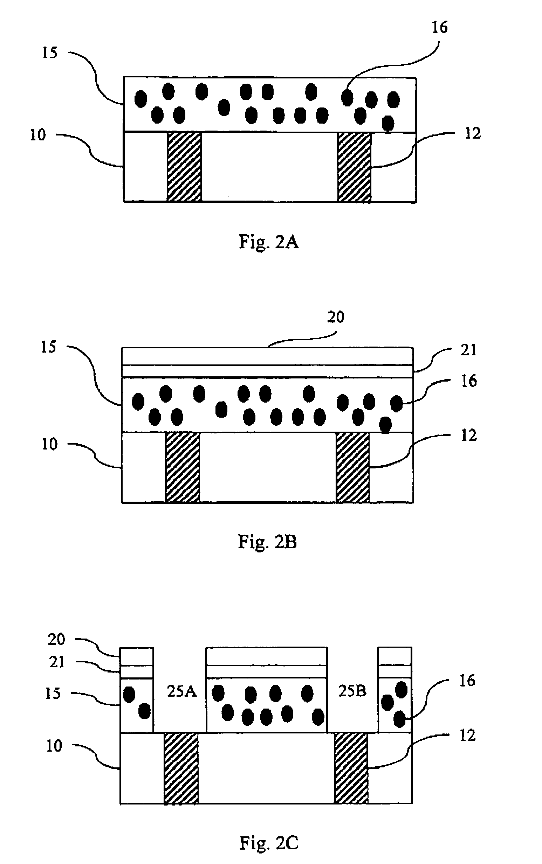

In an alternate embodiment, the porogens are removed after a lithographic step. For example, the porogens may be removed after an etching step or after any metallization step. Figs. 2A-2E illustrate one embodiment of a process where the porogens are removed after a lithographic step. Fig. 2A illustrates an electronic device containing substrate **10,** such as a wafer used in the manufacture of integrated circuits, having metal lines **12** and cured organic polysilica dielectric film **15** including porogens **16** including an organic radical-capped polyol moiety. Photoresist **20** is disposed on the surface of the device and optional antireflective layer **21** is disposed between photoresist **20** and organic polysilica dielectric film **15,** as shown in Fig. 2B. Next, photoresist **20** is exposed to patterned actinic radiation (using a wavelength appropriate for the photoresist selected) and the patterned transferred to antireflective layer **21** and organic polysilica dielectric film **15** to provide apertures **25A** and **25B** as illustrated in Fig. 2C. The photoresist and antireflective layer are then removed using any suitable stripping procedure.

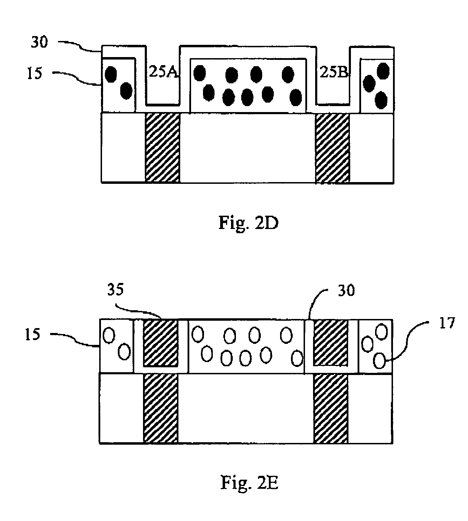

Barrier layer **30** (and/or a seed layer) is disposed on the surface of organic polysilica dielectric film **15** including on the sidewall surfaces in apertures **25A** and **25B,** as shown in Fig. 2D. Apertures **25A** and **25B** are then filled with a metal 35 (such as copper), and the device is subjected to chemical mechanical planarization ("CMP") to remove the metal and barrier layer from the top surface of organic polysilica film **15,** leaving barrier layer **30** and metal **35** within the apertures. Fig. 2E illustrates the electronic device having metal **35** and barrier layer **30** within the apertures after being subjected to conditions to remove the porogen to form pores **17** in organic polysilica dielectric film **15.** Optionally, a porous cap layer may be disposed on the organic polysilica dielectric film prior to the formation of any metal lines. Prior to repeating the above steps to add a further interconnect layer, the deposition of a copper barrier layer, such as silicon carbide or a selective copper barrier layer such as CoWP, may be required.

A variety of electronic devices may be prepared according to the present invention including, but not limited to, interconnect structures, semiconductors, semiconductor packaging, printed wiring boards, and includes optoelectronic devices. As used herein, the term "electronic devices" includes micro-electrical mechanical devices ("MEMS") and nano-electrical mechanical devices ("NEMS"). Suitable MEMS include, without limitation, gears, moveable planes, oscillators, springs, and the like. The term ''optoelectronic devices" is also intended to include photonic devices. Suitable optoelectronic devices include, without limitation, waveguides, splitters, array waveguides, couplers, spectral filters, polarizers, isolators, wavelength division multiplexing structures, optical switches, diffraction gratings, interconnects, attenuators, amplifiers, and the like.

The present porogens provide several advantages in the manufacture of electronic devices having porous organic polysilica dielectric films: improved porogen stability to processing conditions as compared to conventional porogens; reduced porosity and increased film density before the porogen removal step; and less shrinkage of the dielectric film following porogen removal when the present porogens are used.

The porogens of the present invention may also be used as a sacrificial material in the formation of an air gap. The term "sacrificial material" refers to a material that forms a layer of material on a substrate where that material is later removed to leave an air gap. An "air gap" is formed in an area where a sacrificial material was present and then subsequently removed. In one embodiment, the porogens of the present invention contain one or more functional (i.e. polymerizable) groups that can be at least partially polymerized to form a film. Such polymerization may occur by thermally initiation or photoinitiation.

When used as a sacrificial material, the present porogens may be used to form air gaps in devices made by a variety of methods, such as damascene or dual damascene processes, as well as by other device fabrication techniques. In general, the sacrificial material is disposed on a substrate by any suitable methods, such as by spin coating, roller coating, curtain coating and the like. An overlayer material may be disposed on the sacrificial material by any suitable means, including, without limitation, spin coating, roller coating, curtain coating, chemical vapor deposition, lamination and the like. Such methods are well-known to those skilled in the art of depositing dielectric materials. The overlayer material should have sufficient porosity to allow the sacrificial material to be removed through it. Such porosity may be inherent in the material used, such as in the case of silica-based xerogels or aerogels, or may be imparted by other means. Suitable means for imparting porosity include the use of "porogens" or pore forming materials.

The sacrificial material is then removed by subjecting it to conditions which degrade, decompose or otherwise cause the sacrificial material to form volatile fragments or components which can then pass through the porous overlayer material. In one embodiment, the sacrificial material is removed by heating. Such heating may be in an oxygen containing atmosphere such as air or may be in an inert atmosphere such as nitrogen or argon. In general, the present sacrificial materials are removed upon heating at a temperature in the range of 150° to 450° C, or higher. More typically, the sacrificial material is removed upon heating at a temperature of 225° to 400° C. In another embodiment, the sacrificial material is removed by a combination of heat and actinic radiation such as UV light. An advantage of the present invention is that the particular removal temperature of the sacrificial material can be controlled by selection of the monomers used, the cross-linking agents used and by the amount of monomers and cross-linking agents used. Such selection is well within the ability of those skilled in the art. Typically, the present sacrificial material leaves very little residue behind, such as ≤ 10^{%}wt, preferably ≤ 5%wt and more preferably ≤ 2%wt.

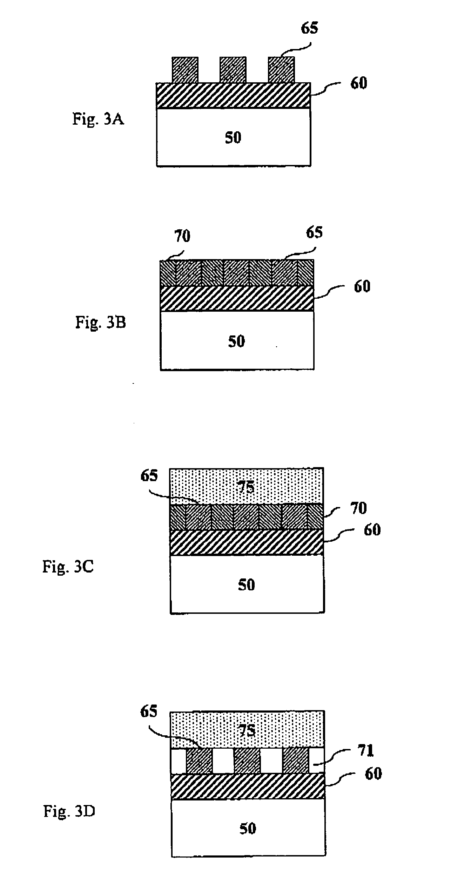

In one embodiment, the sacrificial material is disposed on a substrate that has patterned metal lines. Figs. 3A to 3D illustrate a first embodiment of air gap formation in which metal lines are formed prior to disposing the sacrificial material on the substrate, not to scale. In Fig. 3A, a structure including substrate **50** having dielectric layer **60** disposed on the substrate **50** and metal lines **65** disposed on dielectric layer **60** is provided. A sacrificial material is then disposed on the structure of Fig. 3A and at least partially cured to form the structure of Fig. 3B, where sacrificial material **70** is disposed on dielectric layer **60** and between metal lines **65.** A porous overlayer **75** is then disposed on both sacrificial material **70** and metal lines **65,** as shown in Fig. 3C. The structure of Fig. 3C is then subjected to conditions, such as heating, which degrade, decompose or otherwise cause sacrificial material **70** to form volatile fragments or components which are then removed through porous overlayer **75.** This results in the formation of air gaps **71** where sacrificial material **70** had been present, as shown in Fig.3D.

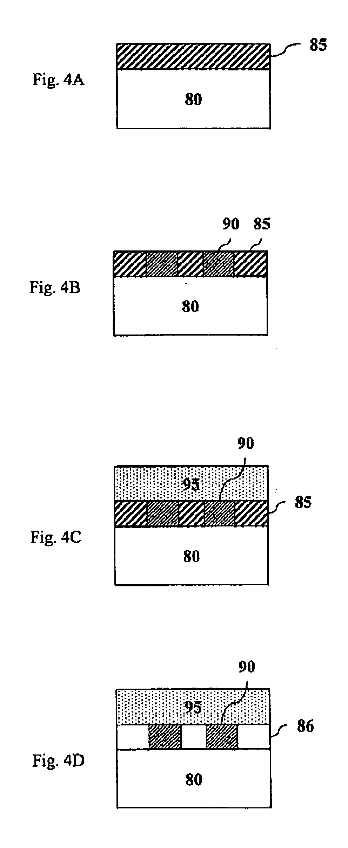

In another embodiment, the sacrificial material may be disposed on a substrate prior to the formation of metal lines in this particular level of the structure. Figs. 4A to 4 D illustrate air gap formation using a sacrificial material in a damascene process, not to scale. Sacrificial material **85** is first disposed on substrate **80** and then cured, as shown in Fig. 4A. Sacrificial material **85** is then patterned. Such patterning may be accomplished by a variety of means such as by disposing a photoresist on the sacrificial material followed by imaging, developing and etching. Alternatively, the sacrificial material itself may be photoimageable. When a photoimageable sacrificial material is used, it may be imaged directly by exposing it to the appropriate wavelength of actinic radiation through a mask, followed by development. Such lithographic processes are well-known to those skilled in the art. Following patterning, metal lines **90** are formed in sacrificial material **85,** as shown in Fig. 4B. Porous overlayer **95** is then disposed on both the sacrificial material **85** and metal lines **90,** as shown in Fig. 4C. The structure of Fig. 4C is then subjected to conditions, such as heating, which degrade, decompose or otherwise cause sacrificial material **85** to form volatile fragments or components which are then removed through porous overlayer material **95.** This results in the formation of air gaps **86** where sacrificial material **85** had been present, as shown in Fig.4D.

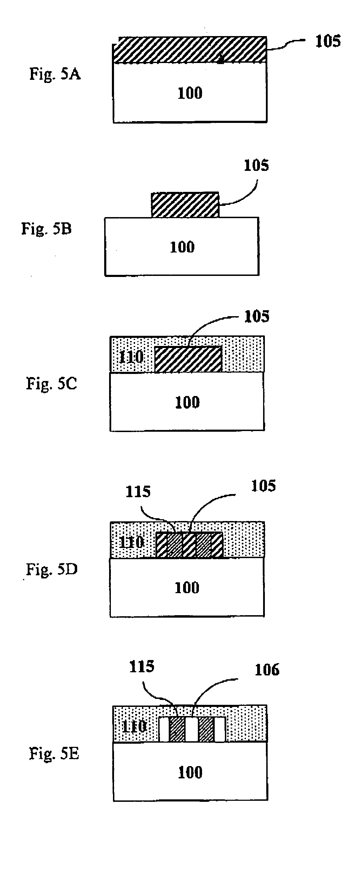

In another embodiment, the sacrificial material may be disposed on a substrate prior to the formation of metal lines in this particular level of the structure. Figs. 5A to 5E illustrate air gap formation using a sacrificial material in a damascene process, not to scale. Sacrificial material **105** is first disposed on substrate **100** and then cured, as shown in Fig. 5A. Sacrificial material **105** is then patterned to leave material only in regions where there will be a high density of metal lines. Such patterning may be accomplished by a variety of means such as by disposing a photoresist on the sacrificial material followed by imaging, developing and etching. Alternatively, the sacrificial material itself may be photoimageable. When a photoimageable sacrificial material is used, it may be imaged directly by exposing it to the appropriate wavelength of actinic radiation through a mask, followed by development. Such lithographic processes are well-known to those skilled in the art. Following patterning, a porous overlayer **110** is then disposed on the sacrificial material **105** and also in areas where the sacrificial material has been removed, as shown in Fig 5C. Porous overlayer **110** and sacrificial material **105** are then patterned as before to create apertures in either the porous overlayer **110** or in both the porous overlayer **110** and the sacrificial material **105.** The metal lines are formed in the apertures as shown in Fig. 5D. The structure of Fig. 5D is then subjected to conditions, such as heating, which degrade, decompose or otherwise cause sacrificial material **105** to form volatile fragments or components which are then removed through porous overlayer material **110.** This results in the formation of air gaps **106** where sacrificial material **115** had been present, as shown in Fig.5E.

In an alternate embodiment af a damascene processes, a barrier layer may be deposited on copper lines prior to the porous overlayer material being disposed on both the sacrificial material and the copper lines. In yet another embodiment of a damascene process, a porous overlayer material is disposed on the sacrificial material prior to the formation of metal lines. Prior to repeating the above steps to add a further interconnect layer, the deposition of a copper barrier layer, such as silicon carbide or a selective copper barrier layer such as CoWP, may be required.

The following examples are expected to illustrate various aspects of the present invention, but are not intended to limit the scope of the invention in any aspect.

### Example 1

A thermally removable porogen polymer particle including as polymerized units the following monomers phenoxy capped polyethylene oxide acrylate/styrene/trimthylolpropane triacrylate (in an 80/15/5 ratio by weight) was formed via solution polymerization.

A 1,000 mL reactor was fitted with a thermocouple, a temperature controller, a purge gas inlet, a water-cooled reflux condenser with purge gas outlet, a stirrer, and an addition funnel. To the addition funnel was charged 133.35 g of a monomer mixture consisting of 84.00 g phenoxy capped polyethylene oxide acrylate containing 4 moles of ethylene oxide (Mn = 324, 100% purity), 15.75 g styrene (100% purity), 5.25 g trimethylolpropane triacrylate (100% purity), 2.10 g of a 75% solution of t-amyl peroxypivalate in mineral spirits (TRIGONOX 125-C75), and 26.25 g propylene glycol methyl ether acetate ("PGMEA"). The reactor, containing 544.60 g PGMEA was then flushed with nitrogen for 60 minutes while applying heat to bring the contents of the reactor to 82°C. When the contents of the reactor reached 82°C, the monomer mixture in the addition funnel was uniformly charged to the reactor over 120 minutes. Thirty minutes after the end of the monomer mixture addition, the first of three chaser aliquots, spaced thirty minutes apart and consisting of 2.10 g of a 75% solution of t-amyl peroxypivalate in mineral spirits (TRIGONOX 125-C75) and 5.25 g PGMEA, was added. At the end of the third chaser aliquot, the contents of the reactor were held 2½ hours at 82°C to complete the reaction. The resulting polymer was passed through an ion exchange column containing IRN-150 ion echange beads (from Rohm and Haas Company) and then filtered through a 0.2µm polytetrafluoroethylene ("PTFE") filter. The porogen particles thus formed had a particle size distribution of from 2 to 20 nm as determined by dynamic laser light scattering and a molecular weight of about 5400 glmol with a number average molecular weight of about 2100 g/mol and Mw/Mn distribution (polydispersity) of 2.6 as measured by GPC.

### Examples 2

The procedure of Example 1 was repeated to prepare the porogen polymers in Table 1 in the amounts specified.

**Table 1**

| **Sample** | **PhOPEOA (wt%)** | **HEMA (wt%)** | **MMA (wt%)** | **Styrene (wt%)** | **TMPTA** | **PAO Chain Length** |
|---|---|---|---|---|---|---|
| 2A | 80.0 | - | - | 15.0 | 5.0 | 4 |
| 2B | 65.0 | 7.5 | 7.5 | 15.0 | 5.0 | 4 |
| 2C | 80.0 | - | - | - | 20.0 | 4 |
| 2D | 42.5 | 15.0 | 15.0 | 15.0 | 12.5 | 4 |
| 2E | 50.0 | 15.0 | 15.0 | 7.5 | 12.5 | 4 |
| 2F | 80.0 | 0.0 | 0.0 | 7.5 | 12.5 | 4 |
| 2G | 35.0 | 15.0 | 15.0 | 15.0 | 20.0 | 4 |
| 2H | 75.0 | - | 0.0 | 10.0 | 15.0 | 4 |
| 21 | 80.0 | 7.5 | 7.5 | 0.0 | 5.0 | 4 |
| 2J | 80.0 | 3.8 | 3.8 | 7.5 | 5.0 | 4 |
| 2K | 50.0 | 15.0 | 15.0 | 15.0 | 5.0 | 4 |
| 2L | 80.0 | 2.5 | 2.5 | 5.0 | 10.0 | 4 |
| 2M | 42.5 | 15.0 | 15.0 | 7.5 | 20.0 | 4 |
| 2N | 57.5 | 15.0 | 15.0 | - | 12.5 | 4 |
| 20 | 80.0 | 3.8 | 3.8 | - | 12.5 | 4 |
| 2P | 50.0 | 15.0 | 15.0 | - | 20.0 | 4 |
| 2Q | 57.5 | 7.5 | 7.5 | 7.5 | 20.0 | 4 |
| 2R | 65.0 | 7.5 | 7.5 | - | 20.0 | 4 |
| 2S | 57.5 | 15.0 | 15.0 | 7.5 | 5.0 | 4 |
| 2T | 68.8 | 9.4 | 9.4 | - | 12.5 | 4 |
| 2U | 57.5 | 7.5 | 7.5 | 15.0 | 12.5 | 4 |
| 2W | 63.1 | 8.4 | 8.4 | 7.5 | 12.5 | 4 |
| 2X | 72.5 | - | - | 7.5 | 20.0 | 4 |
| 2Y | 72.5 | - | - | 15.0 | 12.5 | 4 |
| 2Z | 50.0 | 7.5 | 7.5 | 15.0 | 20.0 | 4 |
| 2AA | 65.0 | - | - | 15.0 | 20.0 | 4 |
| 2BB | 65.0 | 15.0 | 15.0 | - | 5.0 | 4 |
| 2CC | 72.5 | 11.3 | 11.3 | - | 5.0 | 4 |
| 2DD | 68.8 | 9.4 | 9.4 | 7.5 | 5.0 | 4 |
| 2EE | 80.0 | 10.0 | - | - | 10.0 | 4 |
| 2FF | 50.0 | 15.0 | 15.0 | 7.5 | 12.5 | 4 |
| 2GG | 50.0 | 15.0 | 15.0 | 7.5 | 12.5 | 3 |
| 2HH | 53.0 | 22.5 | 22.5 | - | 2.0 | 3 |
| 2II | 50.5 | 15.2 | 15.2 | 12.4 | 6.7 | 4 |
| 2JJ | 50.0 | 15.0 | 15.0 | 7.5 | 12.5 | 4 |
| 2KK | 80.0 | - | - | - | 20.0 | 4 |

In Table 1, the following abbreviations are used: PhOPEOA = phenoxy capped polyethylene oxide acrylate; HEMA = hydroxyethyl methacrylate; MMA = methyl methacrylate; and A = trimethylolpropane triacrylate- PAO chain length refers to the chain length of the ethylene oxide unit in PHOPEOA.

### Example 3

Porous dielectric films were prepared by spin coating a composition containing porogens from Examples 1 or 2, a B-staged organic polysilica dielectric material containing 55 wt% methyl triethoxy silane ("MeTEOS'') and 45 wt% tetraethyl ortho silicate ("TEOS") and PGMEA to a thickness of approximately 6000 to 8000 Å on a wafer. The wafers were then processed at 150° C for 1 minute to remove solvent. The wafers were then heated to 300° on a hot plate for 3 minutes in a nitrogen atmosphere having approximately 60 ppm of O₂, to cure the dielectric film. Following curing of the film, the porogens were removed by heating the samples in a furnace. The oxygen content of the furnace was below 5 ppm before heating of the sample. The sample was placed in the furnace and heated at a rate of 10° C per minute to a temperature of 450° C and held at this temperature for 1 hour, after which the furnace was cooled at a rate of approximately 10° C per minute.

### Example 4

The procedure of Example 3 was repeated except that after curing of the dielectric film at 300° C for 3 minutes, the samples were held at 300° C for 1 hour and the weight loss of the porogen was measured The lower the weight loss, the more stable the porogen to the processing conditions. The porogens tested are reported in Table 2.

**Table 2**

| **Sample** | **Weight loss (%)** |
|---|---|
| 2D | 2.29 |
| 2E | 2.26 |
| 20 | 2.02 |
| 2K | 2.00 |
| 2T | 1.95 |
| 2AA | 1.75 |
| 2BB | 2.35 |
| 2DD | 2.38 |
| 2EE | 2.30 |
| 2FF | 2.20 |
| 2GG | 2.85 |
| 2II | 1.66 |
| | |
| Comparative 1 | 35.00 |
| Comparative 2 | 6.00 |

Comparative sample 1 used as a porogen a polymer containing 90 wt% hydroxy polypropylene oxide methacrylate containing on average 5 to 6 moles of propylene oxide and 10 wt% ethylene glycol dimethacrylate. Comparative sample 2 used as a porogen a polymer containing 90 wt% methoxy capped polypropylene oxide acrylate containing 3 moles of propylene oxide and 10 wt% trimethylolpropane trimethacrylate. Neither comparative sample contained an aryl group-containing capped organic radical according to the present invention.

### Example 5

The procedure of Example 4 is repeated except that the porogens and organic polysilica dielectric materials in Table 3 are used. The results are expected to be similar to those of Example 4.

**Table 3**

| **Sample** | **Porogen** | **Organic Polysilica Monomers (wt% of monomer)** |
|---|---|---|
| 5A | ((PhO(PEO)₄)C(O))₃C₆H₃ | MeTEOS/BTSE (66/34) |
| 5B | ((PhCH₂O(PEO)₄)C(O))₃C₆H₃ | PhTEOS / MeTEOS /BTSE (20/47/33) |
| 5C | (PhO(EO/PO)₁₆)₃C₃H₅ | PhTEOS / MeTEOS /TEOS (20/46/34) |
| 5D | (BzO(EO/PO)₁₆)₃C₃H₅ | PhTEOS / MeTEOS /TEOS (33/33/34) |
| 5E | (PhO(EO/PO)₁₆)₃C₃H₅ | PhTEOS/ MeTEOS /TEOS/DMDES (28/33/34/5) |

In Table 3, the flowing abbreviations are used: MeTEOS = methyl triethoxysilane; BTSE = bistriethoxysilyl ethane; PhTEOS = phenyl triethoxysilane; TEOS = tetraethyl ortho silicate; DMDES = dimethyl diethoxy silane.

### Example 6

The procedure of Example 3 is repeated except that the samples from Example 5 are used. Porous organic polysilica films are expected.

## Claims

1. A composition comprising a B-staged organic polysilica material and a porogen, wherein the porogen comprises an aryl group-containing organic radical-capped polyol moiety.

2. The composition of claim 1 wherein the polyol moiety is substantially free of hydroxyl groups.

3. The composition of claim 1 wherein the polyol moiety comprises an alkylene oxide unit.

4. The composition of claim 1 wherein the polyol moiety comprises one or more units of the formula (-(OC₂-C₄)₂OR¹¹)_{z}, wherein each R¹¹ is independently chosen from aryl, (C₁-C₆)alkylaryl, aracyl, and aroyl, z = 1-50 and z' = 1-10.

5. The composition of claim 4 wherein R¹¹ is chosen from phenyl, tolyl, benzyl, phenethyl, phenacyl, and benzoyl.

6. The composition of claim 4 wherein R¹¹ is phenyl.

7. The composition of claim 1 wherein the porogen is a polymer comprising as polymerized units one or more monomers of the formula R¹²((OC₂-C₄)_{z}OR¹¹)_{z}, wherein each R¹¹ is independently chosen from aryl, (C₁-C₆)alkylaryl, aracyl, and aroyl, z = 1-50 z' = 1-10 and R¹² is acryl or methacryl.

8. The composition of claim 1 wherein the porogen further comprises as polymerized units one or more monomers chosen from (meth)acrylic acid, (meth)acrylamides, alkyl (meth)acrylates, alkenyl (meth)acrylates, aromatic (meth)acrylates, vinyl aromatic monomers, nitrogen-containing compounds and their thio-analogs, and substituted ethylene monomers.

9. A method of preparing porous organic polysilica dielectric materials comprising the steps of a) disposing the composition of claim 1 on a substrate; b) curing the B-staged organic polysilica dielectric material to form an organic polysilica film without substantially degrading the porogen; and c) subjecting the organic polysilica film to conditions which at least partially remove the porogen to form a porous organic palysilica film.

10. A method of manufacturing an electronic device comprising the step of forming a porous organic polysilica film comprising the steps of: a) disposing the composition of claim 1 on an electronic device substrate; b) curing the B-staged organic polysilica dielectric material to form an organic polysilica film without substantially degrading the porogen; and c) subjecting the organic polysilica film to conditions which at least partially remove the porogen to form a porous organic polysilica film.

11. The method of claim 10 wherein the substrate is a wafer used in the manufacture of integrated circuits.

12. An electronic device comprising a substrate and an organic polysilica film, wherein the film comprises a porogen comprising an organic radical-capped polyol moiety.
